# EUROPÄISCHE PATENTSCHRIFT

(11) **EP 0 742 906 B1**
(45) Veröffentlichungstag und Bekanntmachung des Hinweises auf die Patenterteilung: **23.09.1998**
(21) Anmeldenummer: 95905049.3
(22) Anmeldetag: 12.01.1995
(51) Int. Cl.: G01R 33/02, G01V 3/10

(54) **VERWENDUNG EINER MINIATURISIERTEN SPULENANORDNUNG HERGESTELLT IN PLANARTECHNOLOGIE ZUR DETEKTION VON FERROMAGNETISCHEN STOFFEN**
USE OF A MINIATURIZED PLANAR-DESIGN COIL ASSEMBLY FOR THE DETECTION OF FERROMAGNETIC MATERIALS
UTILISATION D'UN DISPOSITIF A BOBINES MINIATURISE, FABRIQUE EN TECHNOLOGIE PLANAIRE, POUR LA DETECTION DE MATIERES FERROMAGNETIQUES

(30) Priorität: 31.01.1994 DE 4402785; 29.11.1994 DE 4442441
(43) Veröffentlichungstag der Anmeldung: 20.11.1996
(73) Patentinhaber: Frauenhofer-Gesellschaft zur Förderung der angewandten Forschung e.V., D-80636 München (DE)
(72) Erfinder: GOTTFRIED-GOTTFRIED, Ralf, D-01109 Dresden (DE); KÜCK, Heinz, D-47249 Duisburg (DE)
(86) Internationale Anmeldenummer: DE9500034
(87) Internationale Veröffentlichungsnummer: WO9520768

(56) Entgegenhaltungen:
- DE-A- 3 420 709
- DE-A- 3 738 455
- GB-A- 2 083 230

## Beschreibung

### Technisches Gebiet

Die Erfindung betrifft die Verwendung einer Anordnung zur Detektion von Stoffen mit von Null verschiedener magnetischer Permeabilität, insbesondere ferromagnetischer Stoffe.

Die erfindungsgemäße Anordnung kann neben der Detektion von Stoffen mit von Null verschiedener magnetischer Permeabilität auch zur indirekten Messung von verschiedenen anderen Größen eingesetzt werden. Dazu muß die zu messende Größe eine Veränderung der magnetischen Permeabilität in der direkten Umgebung der erfindungsgemäßen Anordnung verursachen.

Dies ist beispielsweise bei der Relativbewegung zwischen einer ferromagnetischen Struktur (z. B. einer Struktur bzw. einem Maßstab mit äquidistanten ferrromagnetischen Markierungen) und der erfindungsgemäßen Anordnung der Fall. Auf diese Weise kann zum Beispiel eine Translation einer Zahnstange oder eine Rotation eines Zahnrades, die sich relativ zur erfindungsgemäßen Anordnung bewegen, erkannt werden. In Verbindung mit einem inkrementalen Verfahren können so Position und/oder Winkel bestimmt werden.

Ein weiteres Einsatzgebiet ist die Materialuntersuchung. Mit einer oder mehreren erfindungsgemäßen Anordnungen können Werkstücke abgetastet werden. Die entstehenden Signale sind ein Maß für die magnetischen Eigenschaften bzw. die lokale Variation der magnetischen Eigenschaften (z. B. bestimmter ferromagnetischer Bereiche in Edelstahl) und können so zur Beurteilung und Erkennung eines Werkstückes dienen. Für die Vorwärts- oder Rückwärtsbewegungserkennung eines Körpers bewegt sich etwa eine am Körper angebrachte Struktur aus äquidistanten, magnetischen Markierungen an zwei erfindungsgemäßen Anordnungen, die um 90° gegeneinander gedreht angeordnet sind, vorbei, wobei aus der Signallage der beiden Signale die Bewegungsrichtung der Struktur und damit die des Körpers bestimmt werden kann.

### Stand der Technik

Aus der DE 31 33 061 ist ein Drehwinkelmeßfühler bekannt, der einen Permanentmagnet als flußerzeugendes Bauelement und eine Spule mit Kern als flußdetektierendes Bauelement aufweist. Eine Flußführung mittels ferromagnetischer Materialien existiert nicht; Ausbreitungsmedium ist die Luft. Der vom Permanentmagneten ausgehende Magnetfluß wird in Abhängigkeit der Winkelstellung eines drehbar gelagerten ferromagnetischen Körpers geändert und ruft an den elektrischen Impulsen, die durch die Meßspule geschickt werden, eine Veränderung der Impulsbreite hervor. Durch diese spezielle Detektionsart gelang es, sowohl die Linearität zu verbessern als auch eine zuverlässige Drehwinkelermittlung mit hoher Genauigkeit zu erreichen. Zudem ist eine spezielle geometrische Form des Permanentmagneten nicht mehr erforderlich, sondern er kann eine übliche Konfiguration aufweisen. Nachteilig ist die nicht gezielte Führung des magnetischen Flusses, die in Verbindung mit der Verwendung eines Permanentmagneten eine Miniaturisierung des Drehwinkelmeßfühlers in den Sub-Millimeterbereich unmöglich macht. Darüberhinaus ist die Nichtsteuerbarkeit des magnetischen Flusses eines Permanentmagneten von Nachteil, da sie den Einsatz hochempfindlicher elektrischer Meßverfahren nicht zuläßt, demzufolge einer Verkleinerung des Drehwinkelmeßfühlers sehr enge Grenzen gesetzt sind und optimale Signalqualitäten nicht erreicht werden können.

In der DE 42 38 861 wird eine Vorrichtung zur Bestimmung der Position eines axial beweglichen Körpers beschrieben. Eine oder mehrere Spulen dienen zugleich als flußerzeugende als auch als flußdetektierende Bauelemente. Der zu detektierende Körper hat eine ferromagnetische Schicht, die den magnetischen Fluß in der Meßspule ändert. Dadurch verändert sich auch die Induktivität dieser Spule, was als Impedanzänderung mit einer (Halb)brückenschaltung ausgewertet wird. Die Ziele der Schrift sind eine höhere Ansprechempfindlichkeit und eine weitestgehende Unabhängigkeit von Umgebungsbedingungen. Dazu wird allein die ferromagnetische Schicht, die auf den zu detektierenden Körper aufgebracht ist, optimiert und zwar in der Hinsicht, daß insbesondere durch Erhöhung des elektrischen Widerstandes der ferromagnetischen Schicht dem Problem auftretender Wirbelströme entgegengewirkt wird. Die oben schon angesprochenen Nachteile zufolge einer nicht vorhandenen ferromagnetischen flußleitenden Struktur sind auch hier gültig. Da eine mechanische Fertigung von Drahtspulen unter wenigen Millimetern nicht möglich ist, ist eine Verbesserung der Positionsbestimmung durch Verkleinerung der Vorrichtung ausgeschlossen.

Die DE 41 27 209 offenbart einen Geber zur induktiven Erzeugung eines Meßsignals, das die relative Position zweier Körper zueinander angibt. Der Geber besteht aus einer flußerzeugenden Spule, die von Wechselstrom durchflossen ist, weiterhin aus einer ferromagnetischen flußführenden Struktur, die ringförmig ausgebildet ist, und einer Meßanordnung aus Spulen, die zumindest von einem Teil des erzeugten Magnetflusses durchsetzt sind und Spannungen abgeben, die von der relativen Position zweier Körper zueinander abhängen. Im bevorzugten Ausführungsbeispiel dieser Schrift sind dabei die flußerzeugende Spule und die flußleitende Struktur mit dem ersten Körper und die Meßspulenanordnung mit dem zweiten Körper verbunden, wobei die Meßspulenandordnung entweder als gedruckte Schaltung oder aus Draht(flach)spulen in der Größenordnung von mindestens einigen Millimetern realisiert ist. Die (Induktions)Spannungssignale kommen dadurch zustande, daß sich abhängig von der relativen Position der beiden Körper die Fläche ändert, die der erzeugte Magnetfluß auf der Meßspulenanordnung durchsetzt. Die Änderung des magnetischen Flusses wird durch eine Flächenänderung verursacht und nicht durch Änderung der magnetischen Permeabilität, z. B. des zweiten Körpers. Das Ziel der DE 41 27 209 besteht darin, das resultierende Meßsignal durch geeignete Kombination der gemessenen Induktionsspannungen und durch spezielle geometrisch angeordnete Gruppen von Flächenelementen frei von additiven und multiplikativen Störungen zu bekommen und die Linearität der Kennlinie zu verbessern, insbesondere im Nulldurchgang (beide Körper am "gleichen Ort") und in den Endlagen (beide Körper maximal voneinander entfernt). Nachteilig sind sowohl die hybride Aufbauweise der gesamten Anordnung als auch die geometrischen Dimensionen (mindestens einige Millimeter) der die Ortsauflösung bestimmenden Elemente.

Aus der DE 3031997 ist ein Verfahren zur berührungslosen Messung von Drehmomenten bekannt, wobei auf der Prüflingsoberfläche ein magnetisches Wechselfeld erzeugt und die durch das auftretende Drehmoment hervorgerufene Permeabilitätsänderung der Prüflingsoberfläche mittels eines sondenförmigen, an die Prüflingsoberfläche heranbringbaren Magnetjochs mit vier Polstücken, deren Polflächen der Prüflingsoberfläche gegenüberstehen, erfaßt wird. Das Magnetjoch ist als weichmagnetischer Schalenkern mit einem Innenkern und vier Polstücken ausgebildet. Die Querschnittsfläche durch den Innenkern und je zwei gegenüberliegenden Polstücken ist M-förmig (siehe Fig. 1 in DE 3031997). Der Innenkern ist mit einer Erregerwicklung, die vier Polstücke mit zu einer magnetischen Meßbrücke verschalteten Detektionsdrahtwicklungen versehen. Gemessen wird letztlich eine Symmetrieverschiebung der Induktionsspannungen in der magnetischen Meßbrücke. Auch Ferritkerne in sogenannter X-Form (zwei um 90° zueinander angeordnete U-Kerne) können verwendet werden, wobei aufgrund des Fehlens des Innenkerns die Detektionsdrahtspulen auf den vier Polstücken zugleich als Erregerspulen benutzt werden. Nachteilig ist die sehr beschränkte Auswahl an verfügbaren Kernformen; die eigene Herstellung nicht kommerziell erhältlicher Kerne ist zu aufwendig. Zudem können die vorgestellten Meßköpfe nicht sehr klein gemacht werden; in der DE 3031997 sind Meßkopfdurchmesser von ca. 20 mm angegeben.

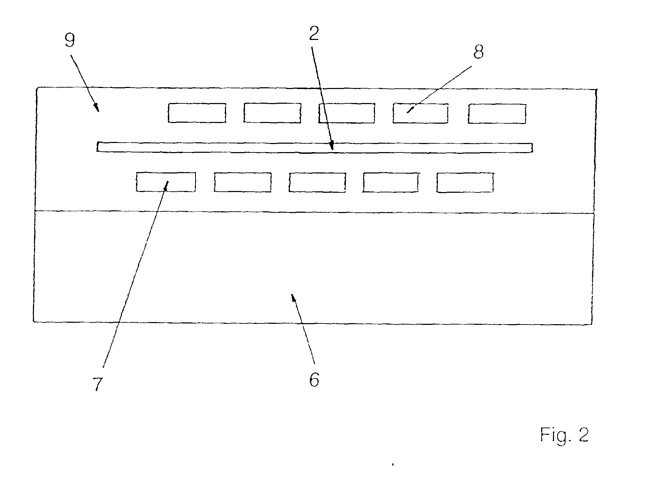

Aus dem Beitrag "An Integrated Sensor Head in Silicon, for Contactless Detection of Torque and Force" in Eurosensors VII, Budapest vom 26.9.93-29.9.93, Seite 351 von P. Rombach ist ebenfalls ein Meßprinzip zur kontaktlosen Messung von Kräften oder Drehmomenten bekannt. Die prinzipielle Meßanordnung besteht aus einem weichmagnetischen U-Kern, an dessen einem Schenkel eine Erregerspule und an dessen anderem Schenkel ein Magnetflußdetektor angebracht sind. In dem Raumbereich in unmittelbarer Nähe zu den beiden Schenkelenden befindet sich ein Metallband mit magnetostriktiven Eigenschaften. Durch Kraft- oder Drehmomenteinwirkung auf das Metallband wird durch Magnetostriktion dessen magnetische Permeabilität geändert. Diese Permeabilitätsänderung wird durch einen Magnetotransistor in einer Stromänderung erfaßt. Die in dem Beitrag vorgeschlagene technische Realisierung (siehe Fig. 2 des Beitrags) ist eine Kombination von Dünnschichttechnik und weiteren mikromechanischen Verfahrensschritten zur Herstellung des magnetischen U-Kerns und der Erregerspule sowie eines CMOS-Prozesses für den Magnetotransistor. Die geometrische Form des U-Kern wird realisiert durch die Ätzung von zwei benachbarten V-Gräben ins Siliziumsubstrat. Die beiden einander nächstliegenden Flanken der beiden V-Gräben bilden die Schenkel des magnetischen Kerns, der jedoch zufolge der endlichen Steilheit der V-Flanken trapezförmige Gestalt hat. Das Kernmaterial besteht aus Nickel und Eisen und wird elektrolytisch abgeschieden. Von großem Nachteil ist, daß diese Herstellungstechnologie nur für sehr einfache Formen magnetischer Kerne tauglich ist.

Aus der DE 37 38 455 A1 ist eine Anordnung zur Messung flussarmer Magnetfelder bekannt. Diese Anordung ist in planarer Mikrotechnologie auf einem einzigen Substrat herstellbar und besteht aus einem Kern aus ferromagnetischem Material, der einen möglicherweise über einen Luftspalt geschlossenen Magnetkreis bildet und der mit mindestens zwei Spulen versehen ist, wobei eine erste der Spulen als Erregerspule dient und eine andere, zweite Spule als Ausgangsspule der Anordnung fungiert. Ferner wird eine Erregerspule mit einem pulsierenden elektrischen Strom gespeist, der stark genug ist, den ferromagnetischen Kern zeitweise in die magnetische Sättigung zu treiben.

Dieser zeitweise Betrieb in der Sättigung ist notwendig, da nur dann in den geradzahligen Oberwellen die Meßinformation über das zu messende Magnetfeld enthalten ist. Insbesondere ist die Amplitude der zweiten Oberwelle nahezu proportional dem zu messenden Wert des externen flussarmen Magnetfeldes. Die sehr starke Grundwelle und generell die ungeradzahligen Oberwellen spielen die Rolle von Störern und stellen eine Art Offsetspannung dar, die enorme Driftprobleme verursachen kann und somit die Meßgenauigkeit deutlich verschlechtert. Solche auf dem in dieser Schrift angewandten Prinzip der Saturationskernsonde beruhende Anordnungen werden auch als Förstersonde oder Fluxgate-Sensor bezeichnet. Bei diesen muß entsprechend den obigen Ausführungen die Amplitude der zweiten Oberwelle detektiert werden. Dies geschieht etwa durch die Trennung der zweiten Oberwelle von den anderen Oberwellen und insbesondere jedoch von der sehr stark störenden Grundwelle mittels Filtern. Auch Kompensationsschaltungen zur Unterdrückung der ersten Oberwelle (Grundwelle) werden eingesetzt. Daneben muß, um sehr schwache Magnetfelder messen zu können, auch das Erdmagnetfeld kompensiert werden, wozu zwei identische Förstersonden in geeigneter, bekannter Weise miteinander verschaltet werden. Durch die Herstellung der bekannten Anordnung in Planartechnologie ist es gelungen, das Störverhältnis der Grundwelle (erste Oberwelle) zur nützlichen zweiten Oberwelle von ca. 1000/1 auf ca. 30/1 zu vermindern. Darüber hinaus muß der ferromagnetische Kern so dimensioniert werden, daß bei minimaler Erregerenergie die zeitweise Sättigung dennoch sicher erreicht wird, was z. B. bedeutet, daß Verluste durch Streuflüsse in vorhandenen Luftspalten des ferromagnetischen Kerns auf ein Minimum reduziert werden müssen. Gleichzeitig muß darauf geachtet werden, daß das zu messende Magnetfeld möglichst gut in den Meßsensor, insbesondere in den ferromagnetischen Kern, eingekoppelt wird, ohne jedoch den Kern zu stark zu entmagnetisieren. Diese Forderungen sind gleichzeitig nur sehr schwer erfüllbar.

### Darstellung der Erfindung

Ausgehend von dem oben dargelegten Stand der Technik, liegt der Erfindung die Aufgabe zugrunde, eine Anordnung aus flußleitenden, flußführenden und flußdetektierenden Bauelementen zur Detektion von Stoffen mit von Null verschiedener Permeabilität derart zu verwenden, daß eine Ortsauflösung im Submillimeter-Bereich bei gleichzeitig hoher Meßempfindlichkeit oder Meßgenauigkeit mit vergleichsweise geringem gerätetechnischem Aufwand erreicht wird und zudem die verwendete Anordnung einfach und kostengünstig in Massenproduktion hergestellt werden kann.

Diese Aufgabe wird durch die Merkmale des Anspruchs 1 gelöst. Bevorzugte Weiterbildungen sind in den Unteransprüchen aufgeführt.

Eine Anordnung, welche erfindungsgemäß zur Detektion von Stoffen mit von Null verschiedener magnetischer Permeabilität verwendet wird, besteht aus den folgenden drei Elementarbausteinen: flußerzeugenden Spulen zur Erzeugung eines magnetischen Flusses, einer flußleitenden Struktur zur Führung des erzeugten magnetischen Flusses an die Meßstellen und flußdetektierenden Bauelementen an den Meßstellen zur Detektion mindestens eines Teils des erzeugten magnetischen Flusses. Die gesamte Anordnung und damit all deren Bestandteile sind auf einem einzigen Substrat durch Planartechnolgie hergestellt.

In einer oder mehreren flußerzeugenden Spulen wird ein magnetischer Fluß (bzw. ein magnetisches Feld) durch einen elektrischen Strom erzeugt. Der erzeugte magnetische Fluß wird durch eine flußleitende Struktur an die Meßstellen der Anordnung, die von den flußerzeugenden Spulen räumlich entfernt sein können, geführt. An diesen Meßstellen sind eine oder mehrere flußdetektierende Bauelemente positioniert, deren geeignet kombinierte Signale ein Maß für die magnetische Permeabilität in der Umgebung der erfindungsgemäßen Anordnung sind.

Es ist günstig, wenn die Werte der magnetischen Flußdichte als Funktion des Ortes in der unmittelbaren Umgebung einer Meßstelle stark von der magnetischen Permeabilität in der Umgebung der Anordnung abhängen. Die geeignete Kombination der Signale kann dabei vorteilhafterweise auf Differenz- und/oder Additionsprinzipien beruhen, zu deren Realisierung eine geeignete Ausbildung der flußdetektierenden Bauelemente (z. B. Wahl des Windungssinnes bei planaren Induktionsspulen), eine geeignete Zusammenschaltung mehrerer flußdetektierender Bauelemente und/oder eine entsprechende Signalverarbeitung beitragen können.

Durch die gesamte erfindungsgemäße Anordnung aus flußerzeugenden Spulen, einer flußleitenden Struktur und flußdetektierenden Bauelementen ist zusammen mit dem vom magnetischen Fluß durchsetzten umgebenden Medium ein geschlossener magnetischer Kreis aufgebaut, in dem die Kirchhoffschen Sätze analog dem elektrischen Fall gültig sind. Durch Annäherung eines externen Objektes mit von Null verschiedener magnetischer Permeabilität werden in der erfindungsgemäßen Anordnung die magnetischen Widerstände verändert. Diese Veränderungen können auf unterschiedlichste Art erfaßt werden. An einem Ort vorzugsweise durch ein oder mehrere flußdetektierende Bauelemente oder durch die Detektion einer Symmetrieverschiebung im magnetischen Kreis. Letzteres erfordert insbesondere eine geeignete Ausbildung der flußleitenden Struktur sowie eine auf diese Struktur angepaßte Auswahl und Festlegung der Meßstellen für die flußdetektierenden Bauelemente. Dabei kann es durch das in der erfindungsgemäßen Anordnung realisierte Meßprinzip vorkommen, daß zumindest ein flußdetektierendes Bauelement von dem Ort oder dem Bereich der Permeabilitätsänderung weiter entfernt ist. Es ist zudem möglich, daß zumindest eine der flußerzeugenden Spulen auch als flußdetektierendes Element verwendet ist. Die Positionierung eines flußdetektierenden Bauelementes geschieht vorzugsweise so, daß entweder der magnetische Fluß in der flußleitenden Struktur detektiert wird oder daß der magnetische (Streu)Fluß, welcher an oder nahe einer Meßstelle aus der flußleitenden Struktur in das umgebende Medium austritt bzw. von dort eintritt, erfaßt wird.

Als flußdetektierende Bauelemente werden dabei vorteilhaft Induktionsspulen oder in Planartechnologie herstellbare Magnetfeldsensoren, beispielsweise magnetoresistive Sensoren, Hallelemente oder Fluxgate-Sensoren, eingesetzt. Bei einer vorteilhaften Anordnung ist eine flußerzeugende Spule von einem elektrischen Strom mit einer zeitlich konstanten und einer zeitlich veränderbaren Komponente von jeweils beliebiger Amplitude durchflossen (z. B. auch reiner Gleichstrom oder reiner Wechselstrom) und mit einem ferromagnetischen Kern versehen. Dieser Kern ist aus hochpermeablem Material und dient deshalb neben der Flußleitung auch als Flußverstärker. Der Spulenkern ist vorzugsweise ein Teil der flußleitenden Struktur, deren Material folgende vorteilhafte Eigenschaften aufweist. Eine hohe Permeabilität erlaubt es, mit vergleichsweise geringem Spulenstrom eine große magnetische Flußdichte zu erzeugen. Dies ist vor allem bei sehr kleinen erfindungsgemäßen Anordnungen zur Erzielung detektierbarer Signale wichtig, da die Stromdichte in den Windungen der flußerzeugenden Spulen einen sehr kleinen Wert hat. Des weiteren ist eine hohe Sättigungsflußdichte des Materials zur Erhöhung der Signale geeignet. Geringe Leistungsverluste werden durch die Verwendung eines weichmagnetischen Materials erreicht, das eine schmale Hysterese aufweist. Materialien, die diese Eigenschaften haben, sind vorzugsweise bestimmte Eisen-Nickel-Legierungen, wobei Beimischungen von Chrom, Mangan, Molybdän und anderen chemischen Elementen weitere Verbesserungen bringen. Die geometrische Ausbildung der flußleitenden Struktur erfolgt vorzugsweise so, daß die flußleitende Struktur aus einer oder mehreren U-förmigen, ferromagnetischen Grundstrukturen aufgebaut ist bzw. umgekehrt in solche zerlegt werden könnte, wie dies etwa bei einer Kamm-förmigen flußleitenden Struktur der Fall ist.

Zur teilweisen oder gänzlichen Kompensation parasitärer Einflüsse können neben passiven Abschirmeinrichtungen zusätzlich weitere flußdetektierende Bauelemente so angeordnet werden, daß sie den magnetischen Fluß einer flußerzeugenden Spule unabhängig von der magnetischen Permeabilität in der Umgebung der Anordnung erfassen und diese Signale zur Kompensation von Störeinflüssen auf eine flußerzeugende Spule und/oder eine flußleitende Struktur, beispielsweise temperaturabhängige Veränderungen der Eigenschaften von ferromagnetischen flußleitenden Strukturen oder externe Magneffelder, benutzen. Die Unabhängigkeit solcher Referenzmessungen von der zu detektierenden magnetischen Permeabilität(sänderung) in der Umgebung der Anordnung muß nicht zu jeder Zeit gegeben sein; oftmals genügt es, diese Unabhängigkeit durch geeignet ausgewählte Modulations- bzw. Meßtechniken zu bestimmten Zeitpunkten oder in bestimmten Zeitintervallen sicherzustelllen. Eine Detektionstechnik auf der Basis von Differenzprinzipien ist generell störungsunempfindlicher. Darüber hinaus werden je nach Anwendungsfall und Aufbau einer erfindungsgemäßen Anordnung Kompensationsmaßnahmen auch zur Erreichung größerer Linearitätsbereiche eingesetzt.

Außer einer einzigen erfindungsgemäßen Anordnung können auf einem Substrat auch mehrere (voneinander unabhängige) erfindungsgemäße Anordnungen in bestimmten Abständen und in bestimmten Winkellagen zueinander hergestellt werden. Die genaue Einstellbarkeit dieser Abstände und Winkel ermöglicht etwa eine Aneinanderreihung erfindungsgemäßer Anordnungen in Zeilen- oder Matrixform (generell beliebige Muster) mit guter Uniformität. Vorteilhaft ist dies für eine genaue und schnelle magnetische Muster- oder Bilderkennung.

Ein wesentliches Charakteristikum der Erfindung ist die Herstellung der erfindungsgemäßen Anordnung mit den Methoden der Planartechnologie auf einem planaren Substrat. Denn durch die gute Maßhaltigkeit der Mikrolithografie (absolute Strukturgenauigkeiten < 1 µm, relative < 1 %), mit der die einzelnen Elementarbausteine strukturiert werden, ist eine Miniaturisierung der erfindungsgemäßen Anordnung in Größenbereiche kleiner als 1 mm realisierbar, wodurch die Ortsauflösung der Messung erheblich gesteigert wird. Aus der Miniaturisierung resultieren auch die Vorteile der geringeren Temeraturabhängigkeit der Meßsignale und der kleineren Störungen durch mechanische Erschütterungen bzw. Schwingungen. Da Magnetfelder eine Ortsabhängigkeit von r⁻ⁿ (n=1...2) aufweisen und so die geometrischen Abmessungen und deren Genauigkeiten sehr starken Einfluß auf die Meßsignale haben, ist es mit der hohen Strukturgenauigkeit, die durch den ausschließlichen Einsatz der Planartechnologie erzielt wird, gelungen, die geometriebedingten Abweichungen der Meßsignale so klein zu halten, daß insbesondere bei der Verwendung von Differenzdetektionsschaltungen Abgleichkosten vermieden wurden.

Ein weiterer Vorteil, der durch die Miniaturisierung und den Einsatz der (CMOS-kompatiblen) Planartechnologie erzielt wird, liegt darin, daß elektronische Schaltungen, z. B. zur Aufbereitung und Auswertung der Meßsignale, neben den flußerzeugenden, flußführenden und flußdetektierenden Bauelementen auf dem Substrat mitintegrierbar sind. Neben einer kostengünstigen und vereinfachten Herstellung hat dies den zusätzlichen Vorteil, daß der Abstand zwischen den flußdetektierenden Bauelementen und der Auswerteelektronik sehr klein gehalten werden kann, somit externe Störungen weniger ins Gewicht fallen und deshalb entweder die Ortsauflösung weiter erhöht werden kann oder noch kleinere Signale detektiert werden können. Letzteres ist auch von Vorteil in dem Fall, bei dem zufolge einer hohen Ortsauflösung die flußdetektierenden Bauelemente nur mit wenigen Spulenwindungen versehen sind und deshalb kleinere Meßsignale detektiert werden müssen. Der Einsatz von Spulen zur Erzeugung eines magnetischen Flusses hat den großen Vorteil, daß zufolge der Steuerbarkeit des erzeugten magnetischen Flusses über den Spulenstrom, hochempfindliche Modulationstechniken zur Detektion auch sehr schwacher und/oder verrauschter Meßsignale verwendbar sind.

Die Erfindung wird nachstehend anhand von Ausführungsbeispielen unter Bezugnahme auf die Zeichnungen näher beschrieben. Es zeigen:
- Figur 1:: Skizze eines Ausführungsbeispiels
- Figur 2:: Schnitt durch eine flußerzeugende Spule (parallel zur Längsachse)
- Figur 3:: Schnitt durch eine flußerzeugende Spule (quer zur Längsachse)
- Figur 4:: Schnitt durch eine planare Spule als flußdetektierendes Bauelement
- Figur 5:: Funktionsprinzip ohne ferromagnetische Umgebung
- Figur 6:: Funktionsprinzip mit ferromagnetischer Umgebung
- Figur 7:: Funktionsprinzip mit zwei planaren Spulen ohne ferromagnetische Umgebung
- Figur 8:: Funktionsprinzip mit zwei planaren Spulen und ferromagnetischer Umgebung

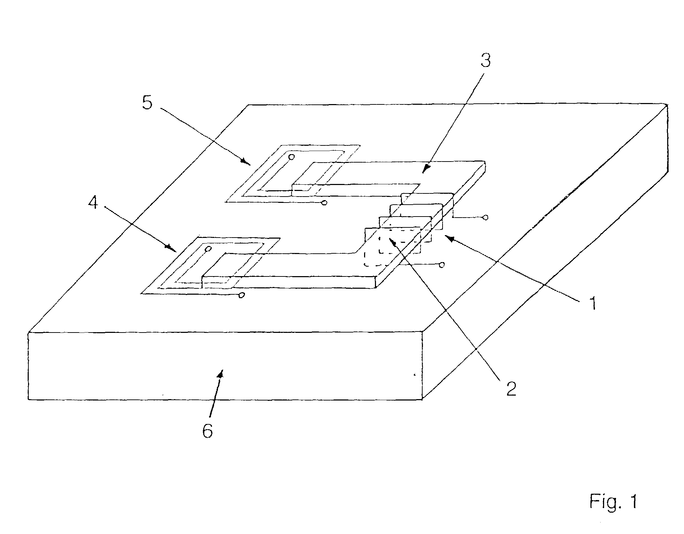

Ein erstes Ausführungsbeispiel ist in Figur 1 dargestellt. Die flußerzeugende Spule (1) besteht aus einer dreidimensionalen Spule mit ferromagnetischem (Spulen)Kern (2), die beide in Planartechnologie hergestellt sind. Der ferromagnetische Kern (2) ist zugleich ein Teil der flußleitenden Struktur (3), die in U-Form ausgebildet ist, wobei die flußerzeugende Spule (1) am Mittelschenkel der U-förmigen flußleitenden Struktur angeordnet ist. An beiden Enden der flußleitenden Struktur ist jeweils ein flußdetektierendes Bauelement (4), (5) angebracht. Die flußerzeugende Spule (1) mit ferromagnetischem Kern (2), die flußleitende Struktur (3) und die flußdetektierenden Bauelemente (4), (5) sind alle auf einem einzigen Substrat (6) gefertigt.

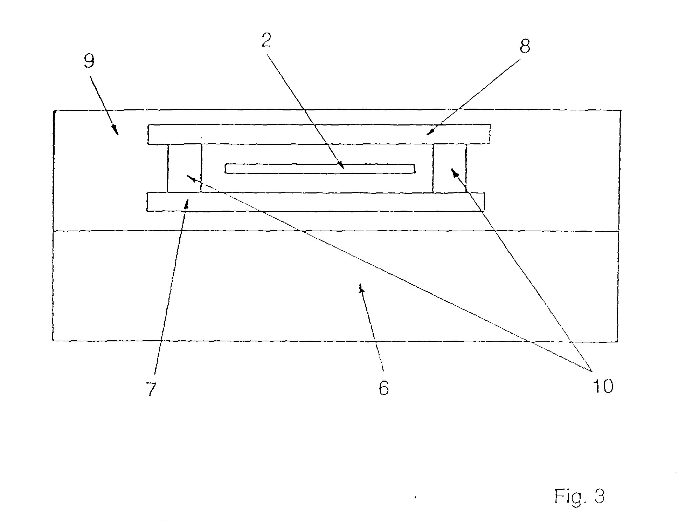

Figur 2 und Figur 3 zeigen einen Längs- bzw. Querschnitt durch die flußleitende Spule mit der flußleitenden Struktur. Die Herstellung einer flußleitenden Spule geschieht durch die Strukturierung einer ersten Metallisierungsebene (7) für den Teil der Spulenwindung, der unter der flußleitenden Struktur (genauer dem ferromagnetischen Kern (2)) angeordnet ist, und durch die Strukturierung einer zweiten Metallisierungsebene (8) für den Teil der Spulenwindung, der über der flußleitenden Struktur angeordnet ist. Die erste und die zweite Metallisierungsebene und der flußleitende und flußverstärkende, ferromagnetische Kern sind jeweils durch eine Isolationsschicht (9) elektrisch voneinander isoliert. Nur im Bereich der Kontaktlöcher (10) ist ein elektrischer Kontakt zwischen der ersten (7) und der zweiten (8) Metallisierungsebene vorhanden, um die Spulenwindungen um den ferromagnetischen Kern (2) herum zu schließen. Die maximale Stromdichte in den Windungen der flußerzeugenden Spule beträgt ca. 1 mA/(µm·µm).

Die beiden Metallisierungsebenen bestehen aus einer ca. 1 µm dicken Aluminiumschicht; die gewählten 50 Spulenwindungen haben eine Breite von ca. 3,2 µm und einen Abstand von ca. 2 µm. Die Isolationsschicht (9) besteht aus einer etwa 1,2 µm dicken Siliziumdioxidschicht und die flußleitende Struktur (3) ist in diesem Ausführungsbeispiel eine ca. 0,5 µm dicke und etwa 100 µm breite Permalloy-Schicht, die aus Nickel (81 %) und Eisen (19 %) zusammengesetzt ist. Diese Schicht kann durch Diffusionsbarriereschichten aus Tantal, das auch als Haftvermittler dient, eingekapselt sein. Für Eisen-Nickel-Schichten sind minimale Strukturbreiten von ca. 5 µm realisierbar, minmale Strukturbreiten für andere Schichten sind 0,5 µm; im Vergleich dazu liegt die Justagegenauigkeit von Struktur zu Struktur bei ca. 1 µm, die bei einer maximalen Bildfläche von ca. 15 mm 15 mm besser als 0,001 ist.

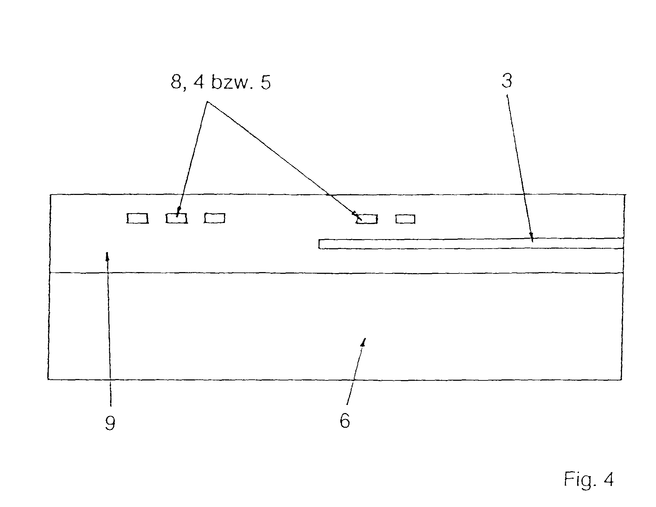

Die flußdetektierenden Bauelemente (4), (5) bestehen, wie in Figur 1 erkennbar ist, aus planaren Spulen, die durch die Strukturierung der zweiten Metallisierungsebene (8) hergestellt sind. Figur 4 zeigt einen Querschnitt durch die Längsachse des U-Schenkels im Bereich einer der beiden flußdetektierenden planaren Spulen.

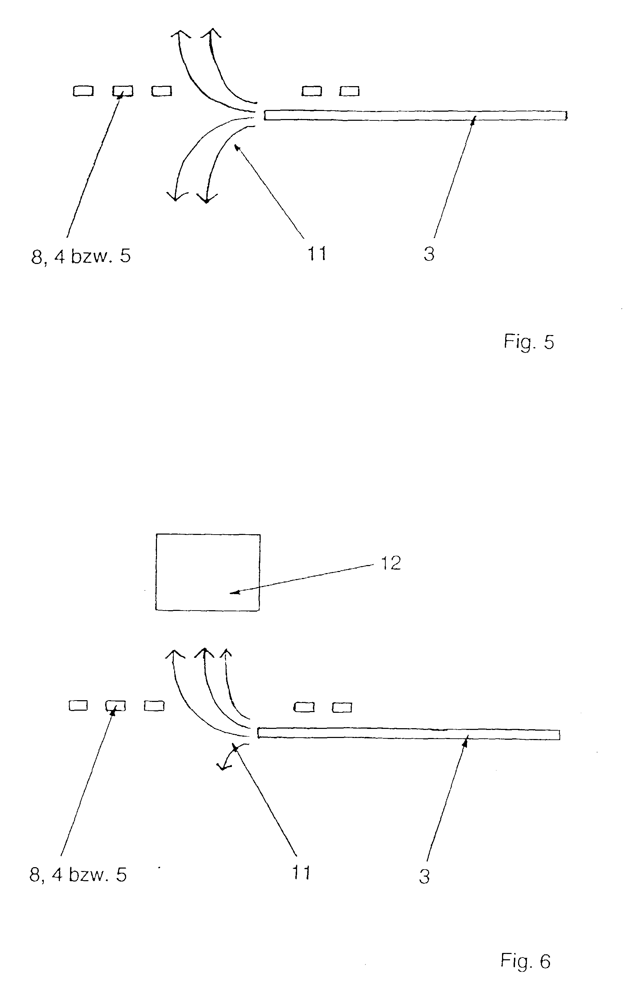

Die flußerzeugende Spule (1) wird im Ausführungsbeispiel von einem Wechselstrom durchflossen. An beiden Enden der U-förmigen, flußleitenden Struktur tritt der erzeugte magnetische Fluß (11) aus bzw. wieder ein, da magnetische Feldlinien immer geschlossen sind. In Figur 5 ist der Fall dargestellt, daß in der Umgebung der Anordnung kein ferromagnetisches Material vorhanden ist. Zumindest ein Teil des magnetischen Flusses durchdringt die planare Spule (4 bzw. 5) und induziert eine Spannung in der Spule. Kommt nun ein ferromagnetischer Körper (12) in die Nähe der Anordnung (Figur 6) so wird der magnetische Fluß, der die planare Spule durchdringt, verändert und dementsprechend entsteht eine geänderte Induktionsspannung, die als Meßsignal dient.

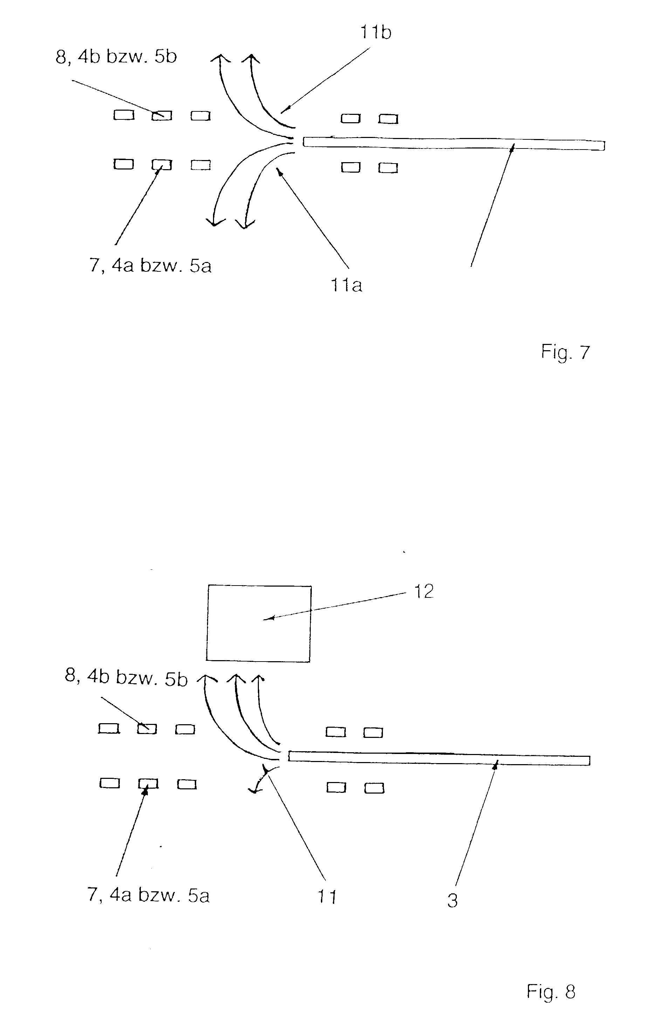

In einem zweiten Ausführungsbeispiel werden durch geeignete Beschaltung zweier planarer Spulen als flußdetektierende Bauelemente die Vorteile von Differenzprinzipien ausgenutzt. In Figur 7 und Figur 8 sind zwei planare Spulen (4a, 4b bzw. 5a, 5b) übereinanderliegend in der ersten und der zweiten Metallisierungsebene angeordnet. Diese beiden planaren Spulen haben den gleichen Windungssinn und sind in Reihe geschaltet, so daß im Fall der Abwesenheit eines ferromagnetischen Körpers und einer komplett symmetrisch ausgeführten Anordnung der planaren Spulen der gleiche magnetische Fluß (11a, 11b) mit entgegengesetztem Vorzeichen die beiden planaren, übereinanderliegenden Spulen durchdringt (Figur 7). Durch die Reihenschaltung heben sich die beiden induzierten Spannungen auf, so daß das resultierende Signal beider Spulen den Wert Null hat, folglich also "kein Signal meßbar ist". Ein externer ferromagnetischer Körper (12) in der Umgebung der beiden Spulen hebt die Symmetrie des magnetischen Flusses (11) am Ort der beiden planaren Spulen auf (Figur 8) und erzeugt auf diese Weise ein von Null verschiedenes (Induktions)Signal in den beiden in Reihe geschalteten Spulen.

In einem weiteren Ausführungsbeispiel wird im Gleichstrombetrieb eine flußerzeugende Spule von einem zeitlich konstanten Strom durchflossen. Als Meßsignale dienen die in den Spulen induzierten Spannungen, die durch eine zeitliche Änderung der magnetischen Permeabilität in der Umgebung verursacht sind.

## Patentansprüche

1. Verwendung einer Anordnung, die aus mindestens einer flußerzeugenden Spule (1) zur Erzeugung eines magnetischen Flusses und einer flußleitenden Struktur (3) zur Führung des erzeugten magnetischen Flusses an mindestens eine Meßstelle und mindestens einem flußdetektierenden Bauelement (4, 5) zur Messung mindestens eines Teils des erzeugten magnetischen Flusses, der an einer Meßstelle wenigstens ein flußdetektierendes Bauelement (4, 5) durchsetzt, besteht, zur Detektion der magnetischen Permeabilität, insbesondere der ferromagnetischer Stoffe, wobei wenigstens ein flußdetektierendes Bauelement (4, 5) ein Signal bereitstellt, das von der magnetischen Permeabilität und deren lokalen Verteilung in der Umgebung der Anordnung abhängt, und wobei die zur Führung des erzeugten magnetischen Flusses dienende flußleitende Struktur sättigungsfrei betrieben wird und weiterhin die flußerzeugenden Spulen (1), die flußleitende Struktur (3) sowie die flußdetektierenden Bauelemente (4, 5) der Anordnung in einer oder mehreren Schichten durch zwei- und/oder dreidimensionale Strukturen, vorzugsweise durch Planartechnologie, realisiert sind und diese Schichten auf einem einzigen Substrat (6) hergestellt sind.

2. Verwendung einer Anordnung nach Anspruch 1,
wobei
von den drei Elementarbausteinen, nämlich den flußerzeugenden Spulen (1), der flußleitenden Struktur (3) und den flußdetektierenden Bauelementen (4,5), nur ein Elementarbaustein oder aber zwei oder auch alle drei Elementarbausteine zumindest eine geometrische Ausdehnung längs einer beliebigen Raumrichtung haben, die im Submillimeter-Bereich liegt.

3. Verwendung einer Anordnung nach einem der Ansprüche 1 bis 2,
wobei
die von den flußdetektierenden Bauelementen (4,5) bereitgesteliten Signale bei geeigneter Kombination und Signalverarbeitung ein resultierendes Signal liefern, das ein Maß für die magnetische Permeabilität in der Umgedung der miniaturisierten Spulenanordnung ist.

4. Verwendung einer Anordnung nach einem der Ansprüche 1 bis 3,
wobei
die flußleitende Struktur (3) so ausgebildet ist, daß an oder nahe bei einer oder mehreren Meßstellen der magnetische Fluß aus der flußleitenden Struktur (3) in das umgebende Medium aus- bzw. eintritt.

5. Verwendung einer Anordnung nach Anspruch 4,
wobei
die gesamte flußleitende Struktur (3) aus einer oder mehreren U-förmigen, flußleitenden Elementarstrukturen aufgebaut ist.

6. Verwendung einer Anordnung nach einem der Ansprüche 1 bis 5,
wobei
die flußleitende Struktur (3) zumindest ein ferromagnetisches Material, vorzugsweise eine Eisen-Nickel-Legierung, enthält.

7. Verwendung einer Anordnung nach einem der Ansprüche 1 bis 6,
wobei
eine flußerzeugende Spule (1) aus einer dreidimensionalen Spule mit einem von ihr umschlossenen Spulenkern (2) besteht.

8. Verwendung einer Anordnung nach Anspruch 7,
wobei
der Spulenkern (2) als Schicht ausgebildet ist, die zumindest ein ferromagnetisches Material, vorzugsweise eine Eisen-Nickel-Legierung, enthält.

9. Verwendung einer Anordnung nach einem der Ansprüche 7 oder 8,
wobei
der Spulenkern (2) ein Teil der flußleitenden Struktur (3) ist.

10. Verwendung einer Anordnung nach einem der Ansprüche 7 bis 9,
wobei
eine flußerzeugende dreidimensionale Spule (1) durch Strukturierungen auf einer ersten (7) und auf einer zweiten (8) Metallisierungsebene und durch elektrisch leitende Kontaktverbindungen (10) zwischen diesen beiden Metallisierungsebenen gebildet ist.

11. Verwendung einer Anordnung nach Anspruch 10,
wobei
sich der Spulenkern (2) zwischen der ersten (7) und der zweiten (8) Metallisierungsebene befindet und daß dieser Spulenkern (2) sowohl von der ersten (7) als auch von der zweiten (8) Metallisierungsebene durch Isolationsschichten (9) elektrisch isoliert ist.

12. Verwendung einer Anordnung nach Anspruch 11,
wobei
eine Isolationsschicht (9) aus Siliziumnitrid und/oder Siliziumdioxid besteht und daß die beiden Metallisierungsebenen (7,8) aus Aluminium hergestellt sind.

13. Verwendung einer Anordnung nach einem der Ansprüche 1 bis 12,
wobei
einer flußerzeugenden Spule (1) ein Strom einprägbar ist, der eine zeitlich konstante und eine zeitlich veränderbare Komponente mit jeweils beliebiger Amplitude besitzt.

14. Verwendung einer Anordnung nach einem der Ansprüche 1 bis 13,
wobei
die flußdetektierenden Bauelemente (4,5) als Induktionsspulen, magnetoresistive Sensoren, Hallelemente oder Fluxgate-Sensoren ausgebildet sind.

15. Verwendung einer Anordnung nach Anspruch 14,
wobei
eine Induktionsspule (4) durch Strukturierungen auf nur einer Metallisierungsebene (7) als planare Induktionsspule ausgebildet ist.

16. Verwendung einer Anordnung nach einem der Ansprüche 14 bis 15,
wobei
eine Induktionsspule (4) einen Kern enthält, der aus wenigstens einem ferromagnetischen Material besteht.

17. Verwendung einer Anordnung nach einem der Ansprüche 14 bis 16,
wobei
an einer Meßstelle als flußdetektierende Bauelemente (4a,4b) zwei planare Induktionsspulen mit dem gleichen Windungssinn in Reihe geschaltet und symmetrisch ausgebildet sind, so daß bei magnetischer Permeabilität Null in der Umgebung der Anordnung oder/und bei symmetrischer Verteilung der Permeabilität in der Umgebung der Anordnung das resultierende Signal beider Induktionsspulen den Wert Null hat.

18. Verwendung einer Anordnung nach Anspruch 17,
wobei
die beiden planaren Induktionsspulen (4a,4b) räumlich übereinanderliegend in der ersten (7) und der zweiten (8) Metallisierungsebene angeordnet sind.

19. Verwendung einer Anordnung nach einem der Ansprüche 1 bis 18,
wobei
zur Vermeidung oder Kompensation des Einflusses von Temperaturänderungen oder externen Magnetfeldern oder anderen Störungen spezielle räumliche Anordnungen der flußdetektierenden Bauelemente (4,5) und/oder eine geeignete Signalverarbeitung und/oder entsprechende Abschirmvorrichtungen vorgesehen sind.

20. Verwendung einer Anordnung nach einem der Ansprüche 1 bis 19,
wobei
daß ein oder mehrere weitere flußdetektierende Bauelemente so angeordnet sind, daß durch sie der magnetische Fluß wenigstens einer flußerzeugenden Spule (1) und/oder der magnetische Fluß in der flußleitenden Struktur (3) unabhängig von der magnetischen Permeabilität in der Umgebung der Anordnung erfaßbar und zur Kompensation von Störeinflüssen einsetzbar ist.

21. Verwendung mehrerer Anordnungen nach einem der Ansprüche 1 bis 20,
wobei
mehrere Anordnungen in vorgebbaren Abständen und vorgebbaren gegenseitigen Winkellagen auf einem einzigen Substrat (6) gefertigt sind.

22. Verwendung mehrerer Anordnungen nach Anspruch 21,
wobei
mehrere Anordnungen in Zeilen- oder Matrixform aneinandergereiht sind.

## Claims

1. Use of an arrangement which consists of at least one flux-generating coil (1) for generating a magnetic flux and a flux-conducning structure (3) for passing the generated magnetic flux to at least one measuring point, and of at least one flux-detecting component (4,5) for measuring at least a part of the generated magnetic flux, which, at a measuring point, passes through at least one flux-detecting component (4,5) for detecting the magnetic permeability, particularly of fero-magnetic materials, at least one flux-detecting component (4,5) providing a signal which depends on the magnetic permeability and its local distribution in the environment of the arrangement, and the flux-detecting structure serving to pass the generated magnetic flux being operated free of saturation, and further the flux-generating coils (1), the flux-conducting structure (3) and the flux-detecting components (4,5) of the arrangement are produced in one or a plurality of layers by two- and/or three-dimensional structures, preferably by planar technology, and these layers are produced on a single substrate (6).

2. Use of an arrangement according to claim 1,
whereby of the three elementary components, i.e. the flux-generating coils (1), the flux-conducting structure (3) and the flux-detecting components (4,5) only one elementary component or two or also all three elementary components have at least one geometric extension along an optional spatial direction, which lies in the sub-millimetre range.

3. Use of an arrangement according to one of claims 1 to 2,
whereby the signals provided by the flux-detecting components (4,5), with a suitable combination and signal processing, provide a resultant signal which is a measure of the magnetic permeability in the environment of the miniaturised coil arrangement.

4. Use of an arrangement according to one of claims 1 to 3,
whereby the flux-conducting structure (3) is so formed that, at or close by, when there are one or more measuring points, the magnetic-flux emerges from or enters into the surrounding medium from the flux-conducting structure (3).

5. Use of an arrangement according to claim 4,
whereby the entire flux-conducting structure is built up from one or more U-shaped flux-conducting elementary structures.

6. Use of an arrangement according to one of claims 1 to 5,
whereby the flux-conducting structure (3) contains at least one ferro-magnetic material, preferably an iron-nickel alloy.

7. Use of an arrangement according to one of claims 1 to 6,
whereby a flux-generating coil (1) consists of a three-dimensional coil with a coil core (2) surrounded therewith.

8. Use of an arrangement according to claim 7,
whereby the coil core (2) is in the form of a layer, which contains at least one ferro-magnetic material, preferably an iron-nickel alloy.

9. Use of an arrangement according to one of claims 7 or 8,
whereby the coil core (2) is a part of the flux-conducting structure (3).

10. Use of an arrangement according to one of claims 7 to 9,
whereby a flux-generating three-dimensional coil (1) is formed by structurings on a first (7) and on a second (8) metallising plane and by electrically conductive contact connections (10) between these two metallising planes.

11. Use of an arrangement according to claim 10,
whereby the coil core (2) is located between the first (7) and the second (8) metallising plane, and in that this coil core (2) is electrically insulated both from the first (7) and the second (8) metallising plane by insulating layers (9).

12. Use of an arrangement according to claim 11,
whereby an insulating layer (9) consists of silicon nitride and/or silicon dioxide, and in that the two metallising planes (7,8) are made of aluminium.

13. Use of an arrangement according to one of claims 1 to 12,
whereby there may be impressed on a flux-generating coil (1) a current which has a chronologically constant and a chronologically alterable component with respectively optional amplitudes.

14. Use of an arrangement according to one of claims 1 to 13,
whereby the flux-detecting components (4,5) are formed as induction coils, magneto-resistive sensors, Hall elements of flux-gate sensors.

15. Use of an arrangement according to claim 14,
whereby an induction coil (4) is formed as a planar induction coil by structurings on only one metallising plane (7).

16. Use of an arrangement according to one of claims 14 to 15,
whereby an induction coil (4) contains a core which consists of at least one ferro-magnetic material.

17. Use of an arrangement according to one of claims 14 to 16,
whereby, at a measuring point, two planar induction coils with the same direction of winding are incorporated in series and symmetrically as flux-detecting components (4a,4b), so that when the magnetic permeability is zero in the environmemt of the arrangement or/and when there is symmetrical distribution of the permeability in the environment of the arrangement, the resultant signal of both induction coils has the value zero.

18. Use of an arrangement according to claim 17,
whereby the two planar induction coils (4a,4b) are disposed spatially one above the other in the first (7) and in the second (8) metallising plane.

19. Use of an arrangement according to one of claims 1 to 18,
whereby, in order to avoid, or to compensate for the influence of, temperature alterations or external magnetic fields or other disturbances, special spatial arrangements of the flux-detecting components (4,5) and/or an appropriate signal processing and/or corresponding screening devices are provided.

20. Use of an arrangement according to one of claims 1 to 19,
whereby one or more further flux-detecting components are so disposed that by their means the magnetic flux of at least one flux-generating coil (1) and/or the magnetic flux in the flux-conducting structure (3) may be detected independently of the magnetic permeability in the environment of the arrangement, and may be used to compensate for disturbing influences.

21. Use of a plurality of arrangements according to one of claims 1 to 20,
whereby a plurality of arrangements are produced in predeterminable spacings and predeterminable mutual angular positions upon one single substrate (6).

22. Use of an arrangement according to claim 21,
whereby a plurality of arrangements are aligned with one another in a linear or matrix form.

## Revendications

1. Application d'un dispositif formé d'au moins une bobine génératrice de flux (1) pour générer un flux magnétique et d'une structure conductrice de flux (3) pour conduire le flux magnétique généré vers au moins un point de mesure ainsi qu'au moins un composant (4, 5) pour mesurer au moins une partie du flux magnétique générée, traversant au moins un composant de détection de flux (4, 5) au point de mesure, pour détecter la perméabilité magnétique notamment de matière ferromagnétique,
au moins un composant de détection de flux (4, 5) fournissant un signal dépendant de la perméabilité magnétique et de sa distribution locale dans l'environnement du dispositif et,
la structure conductrice de flux servant à guider le flux magnétique généré fonctionnant hors saturation et en outre les bobines génératrices de flux (1), la structure conductrice de flux (3) ainsi que les composants de détection de flux (4, 5) du dispositif sont réalisés dans une ou plusieurs couches par des structures à deux et/ou trois dimensions de préférence en technique planaire, et ces couches sont fabriquées sur un substrat unique (6).

2. Application d'un dispositif selon la revendication 1
selon lequel
parmi les trois composants élémentaires à savoir les bobines génératrices de flux (1), la structure conductrice de flux (3) et les composants détectant le flux (4, 5) un seul composant élémentaire ou également deux mais également tous les trois composants élémentaires ont une extension géométrique dans une direction quelconque de l'espace qui se situe dans le domaine submillimètrique.

3. Application d'un dispositif selon l'une des revendications 1 et 2,
selon laquelle
les signaux fournis par les composants de détection de flux (4, 5) donnent pour une combinaison appropriée et un traitement de signal, un signal résultant qui est une mesure de la perméabilité magnétique dans l'environnement du dispositif de bobines miniaturisé.

4. Application d'un dispositif selon les revendications 1 à 3,
selon laquelle
la structure conductrice de flux (3) est réalisée pour qu'au niveau ou à proximité d'un ou plusieurs points de mesure, le flux magnétique de la structure conductrice de flux (3) pénètre ou sort du milieu environnant.

5. Application d'un dispositif selon la revendication 4
selon laquelle
l'ensemble de la structure conductrice de flux (3) est formé d'une ou plusieurs structures élémentaires en forme de U conductrices de flux.

6. Application d'un dispositif selon l'une des revendications 1 à 5, selon laquelle la structure conductrice de flux (3) contient au moins une matière ferromagnétique de préférence un alliage fer-nickel.

7. Application d'un dispositif selon l'une des revendications 1 à 6,
selon laquelle
une bobine régérant le flux (1) est une bobine tridimensionnelle avec un noyau (2) entouré par la bobine.

8. Application d'un dispositif selon la revendication 7
selon laquelle
le noyau de bobine (2) est en forme de couche comportant au moins une matière ferromagnétique de préférence en alliage fer-nickel.

9. Application d'un dispositif selon la revendication 7 ou 8,
caractérisée en ce que
le noyau de bobine (2) fait partie de la structure conductrice de flux (3).

10. Application d'un dispositif selon la revendication 7 à 9,
selon laquelle
une bobine tridimensionnelle (1) générant le flux est formée par mise en structure dans un premier (7) et second (8) plan de métallisation et par des liaisons de contact conducteur électrique (10) entre les deux plans de métallisation.

11. Application d'un dispositif selon la revendication 10,
selon laquelle
le noyau de bobine (2) se trouve entre le premier (7) et le second (8) plan de métallisation et ce noyau de bobine (2) est isolé électriquement à la fois du premier plan de métallisation (7) et du second plan de métallisation (8) par des couches d'isolation électriques (9).

12. Application d'un dispositif selon la revendication 11
selon laquelle
une couche d'isolation (9) est en nitrure de silicium et/ou dioxyde de silicium et les plans de métallisation (7, 8) sont en aluminium.

13. Application d'un dispositif selon l'une des revendications 1 à 12,
selon laquelle
une bobine (1) générant le flux peut recevoir un courant constant dans le temps et ayant une composante variable dans le temps est d'une amplitude quelconque.

14. Application d'un dispositif selon l'une des revendications 1 à 13,
selon laquelle
les composants de flux (4, 5) sont des bobines d'induction, pour des capteurs magnétorésistants, des éléments à effet Hall, ou des capteurs Fluxgate.

15. Application d'un dispositif selon la revendication 14
selon laquelle
une bobine d'induction (4) est réalisée par mise en structure sur seulement un plan de métallisation (7) comme bobine d'induction planaire.

16. Application d'un dispositif selon les revendications 14 et 14
selon laquelle
une bobine d'induction (4) contient un noyau formé au moins en matière ferromagnétique .

17. Application d'un dispositif selon les revendications 14 à 16,
selon laquelle
un point de mesure le composant de flux (4a, 4b) comporte deux bobines d'induction planaires avec le même sens d'enroulement, branché en série et réalisé symétriquement, de sorte que pour une perméabilité magnétique nulle dans l'environnement du dispositif et/ou pour une répartition symétrique de la perméabilité d'un environnement du dispositif, le signal résultant fourni par les deux bobines d'induction a pour valeur zéro.

18. Application d'un dispositif selon la revendication 17, les deux bobines d'induction planaires (4a, 4b) sont superposées dans l'espace dans le premier plan de métallisation (7) et dans le second plan de métallisation (8).

19. Application d'un dispositif selon les revendications 1 à 18,
selon lesquelles
pour éviter ou compenser l'influence des variations de température ou des champs magnétiques externes ou autres perturbations, on a des dispositions spatiales particulières des composants de détection de flux (4, 5) et/ou un traitement approprié du signal et/ou des dispositifs formant écrans appropriés.

20. Application d'un dispositif selon les revendications 1 à 19
selon lesquelles
un ou plusieurs autres composants de détection de flux sont disposés pour être traversés par le flux magnétique d'au moins une bobine générant le flux (1) et/ou le flux magnétique dans la structure conductrice de flux (3) indépendamment de la perméabilité magnétique dans l'environnement du dispositif et pour compenser les perturbations.

21. Application d'un dispositif selon les revendications 1 à 20
selon lesquelles
plusieurs dispositions sont prévues à des intervalles prédéterminés et dans des positions angulaires réciproques sur un unique support (6).

22. Application d'un dispositif selon la revendication 21
selon laquelle
plusieurs dispositifs sont rangés en ligne ou en matrice.
